# EUROPEAN PATENT APPLICATION

(11) **EP 3 941 177 A1**
(43) Date of publication of application: **19.01.2022**
(21) Application number: 20185488.2
(22) Date of filing: 13.07.2020
(51) Int. Cl.: H05K 13/08, G06T 7/00, G06N 20/00

(54) **INSPECTION AND PRODUCTION OF PRINTED CIRCUIT BOARD ASSEMBLIES**

(71) Applicant: Siemens Aktiengesellschaft, 80333 München (DE)
(72) Inventor: Fiebag, Daniel, 91052 Erlangen (DE); Kleefeldt, Alexander, 91054 Erlangen (DE)

(57) **Abstract**

A method of inspecting a printed circuit board, PCB, assembly (C) comprising the steps of: acquiring an image (IM) of the PCB assembly (C), e.g., using a camera, and analyzing the image (IM), wherein the analysis comprises an object-based analysis of the image (IM) for recognizing at last one component (A) placed on the PCB (B), and determining whether the at least one component (A) is placed on the PCB (B) based on a comparison between a finding of the object-based analysis and stored assembly information for the PCB (B).

## Description

### TECHNICAL FIELD

The present disclosure relates to printed circuit board, PCB, assemblies as well as their production by way of soldering. More particularly the present disclosure relates to the inspection of PCB assemblies during production. Furthermore, the present disclosure relates to the field of artificial intelligence and machine learning and its industrial application.

### BACKGROUND

Automated inspection of printed circuit board, PCB, assemblies is becoming more important as electronics devices get smaller and packing density gets higher. Automated inspection has better performance than manual inspection in terms of consistency, speed and lower cost in the long run.

A printed circuit board (PCB) mechanically supports and electrically connects electrical or electronic components using conductive tracks, pads and other features etched from one or more sheet layers of copper laminated onto and/or between sheet layers of a non-conductive substrate. Components are generally soldered onto the PCB to both electrically connect and mechanically fasten them to it.

The commonly found defects on a PCB assembly include missing components, misalignment, titled components, tombstoning/open circuit, wrong components, wrong value, bridging/short circuit, bent leads, wrong polarity, extra components, lifted leads, insufficient solder, excessive solder among others.

From US20150246404A1 Soldering System Power Supply Unit, Control Unit, Administration Device, and Power Supply-and-Control Device have become known.

From EP0871027A2 inspection of print circuit board assembly has become known and from KR20090049009A an optical inspection apparatus of printed circuit board and method of the same has become known.

### SUMMARY

Nowadays, due to the high variety of PCB assemblies to be produced, the workers assembling the PCBs with the electrical components are confronted with a high number of different components to be mounted on the same or similar PCB types. This may lead to faults when placing the components on a particular PCB due to the workers confusing one layout with another. Usually, a PCB assembly is only inspected after soldering the components to the printed circuit board. Hence, leading to a lot of PCB assemblies being discarded and thus to loss of material and waste.

It is thus an object of the present invention to improve the use of material, to simplify the production process flow and to thereby reduce the number of defectively produced PCB assemblies.

The object is achieved by the following aspects.

According to a first aspect the object is achieved by a method of inspecting a printed circuit board, PCB, assembly. The method comprising the step of acquiring an image of the PCB assembly, e.g., using a camera, and analyzing the image, wherein the analysis comprises an object-based analysis of the image for recognizing at last one component placed on the PCB. The method further comprising the step of determining whether the at least one component is placed on the PCB based on a comparison between a finding of the object-based analysis and stored assembly information for the PCB.

According to a second aspect the object is achieved by a method of training a machine learning algorithm of an object-based analysis program. The method comprising the step of acquiring a plurality of images of a PCB assembly, preferably for different types of PCB assemblies, most preferably during production of the PCB assembly. The method further comprising selecting, from the plurality if images, images suitable for training the machine learning algorithm. The method further comprising automatically labeling the plurality of images based on a template for labeling of the PCB assembly. The method further comprising training the machine learning algorithm based on the labeled images.

According to a third aspect the object is achieved by an inspection system for inspecting a printed circuit board, PCB, assembly. The system comprising a camera for acquiring an image of the PCB assembly. The system further comprising a control unit for analyzing the image, wherein the analysis comprises an object-based analysis of the image for recognizing at last one component placed on the PCB. The control unit further serves for determining whether the at least one component is placed on the PCB based on a comparison between a finding of the object-based analysis and stored assembly information for the PCB.

Further advantageous embodiments are provided in the dependent claims and are described in the following.

### BRIEF DESCRIPTIONS OF THE DRAWINGS

Figure 1 shows a plurality of steps during the production of a PCB assembly, in particular placement of electrical components and soldering of the PCB assembly.
Figure 2 shows an automatic optical inspection during the production of a PCB assembly and after the soldering of the electrical components to the PCB.
Figure 3 shows a plurality of steps during the production of a PCB assembly according to a first embodiment, where the optical inspection is performed before soldering the electrical components to the PCB.
Figure 4 shows an image from a PCB assembly comprising a PCB and electrical components placed on the PCB.
Figure 5 shows a result of an object-detection analysis of an image of the PCB assembly.
Figure 6 shows a system and corresponding steps for inspecting a PCB assembly.
Figure 7 shows a system and corresponding steps for training a machine learning model in order to perform an object-detection of an image of a PCB assembly.
Figure 8 shows a workflow for inspecting a PCB assembly and the integration of the inspection in a production of PCB assemblies.

### DETAILED DESCRIPTION

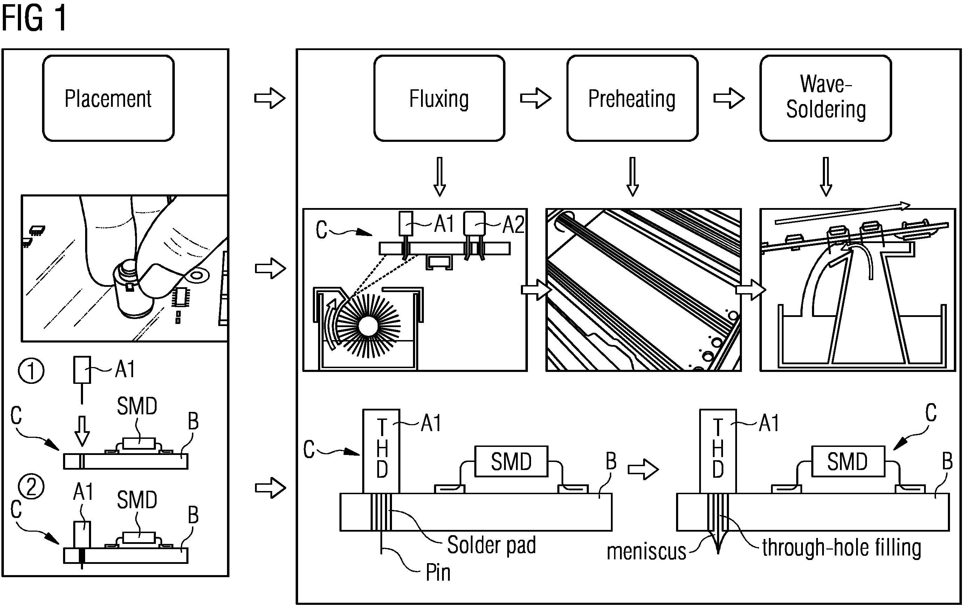

Figure 1 shows a plurality of steps during the production of a PCB assembly C, in particular placement of electrical components A1, A2, SMD and soldering of the PCB assembly C. For the production of a PCB assembly C electrical components A1, A2, SMD are placed on the PCB B. For example, the electrical components A1, A2 such as through-hole devices A1, A2, e.g. capacitors and/or integrated circuits, may be placed on the PCB B. Additionally, electrical components may be surface mount devices SMD and may also be placed on the PCB B.

Through-hole technology, THT, refers to the mounting scheme used for electronic components A1, A2 that involves the use of leads on the components that are inserted into holes drilled in PCBs C and soldered to pads on the opposite side either by manual assembly (hand placement) or by the use of automated insertion mount machines. Through-hole mounting provides strong mechanical bonds when compared to surface-mount technology.

After placing the electrical components A1, A2 on the PCB B, the PCB assembly C is subject to a soldering process. Exemplary a wave soldering process is illustrated in Figure 1 where first a flux is applied to the PCB assembly C which is subsequently preheated. Finally, the PCB assembly C is transported over a standing wave of solder where the PCB B and the components A1, A2 make contact with the solder.

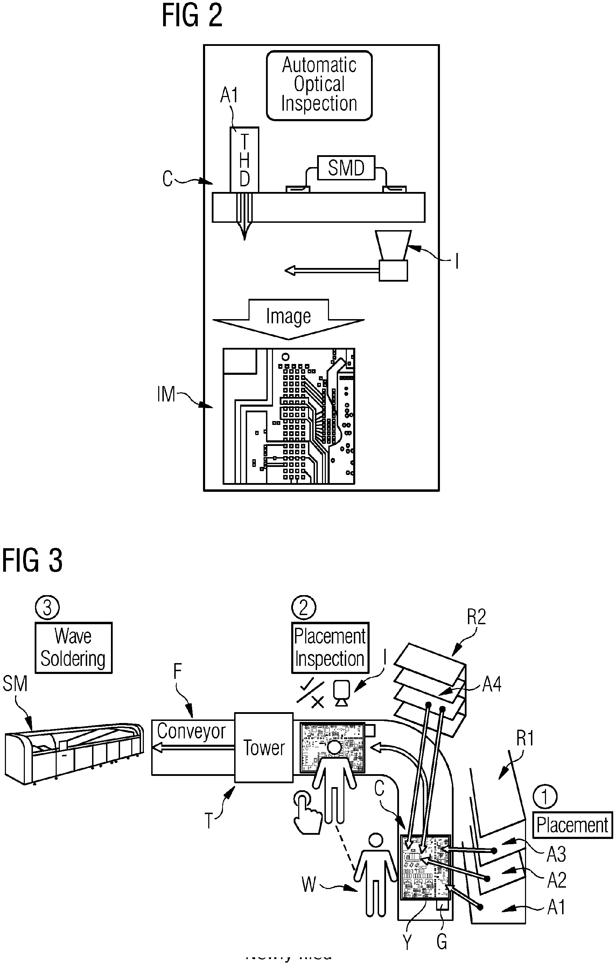

Turning to Figure 2, an automatic optical inspection during the production of a PCB assembly C is shown. Usually the automatic optical inspection is performed after soldering the one or more electrical components A1, SMD to the PCB B. To that end, an image IM is taken by a camera I of the bottom side of the PCB assembly C.

As already mentioned, the rising complexity and variety of electrical devices also leads to higher requirements for the worker(s) assembling the PCBs C with electrical components A1. As the case may be, electrical components A1 may be forgotten, or the wrong components A1 may be placed on the PCB B. In such a case the inspection of the PCB assembly C after the soldering either requires a high effort of de-soldering the PCB assembly C and removing the component(s) wrongly installed or in the worst case, the PCB assembly C needs to be discarded.

Accordingly, it is proposed to perform an automated optical inspection of the PCB assembly C after placing the one or more electrical components A1 on the PCB B and before the soldering of the electrical components A1 to the PCB B. In Figure 3 a plurality of steps during the production of a PCB assembly C are shown, where the optical inspection is performed before soldering the one or more electrical components A1-A4 to the PCB B.

A PCB B may arrive at a placement station 1 at which a worker may place the electrical components A1-A4 on the PCB B. The PCB B may be placed on or in a tray Y for transporting the PCB B along the production line via a conveyor F. The worker may pick the electrical components A1-A4 from one or more shelves R1, R2 at the placement station and place the components A1-A4 according to the type of PCB assembly C to be produced. Alternatively, the placement may be performed automatically, e.g. by a robot.

The wave soldering station 3 may comprise a single wave, not shown. In order to transport the assemblies from the placement station 1 or the inspection station 2to the soldering station 3 a tower T for storing a plurality of PCB assemblies may be provided. The tower may serve as a buffer for loading the soldering machine, e.g., if the placement of electrical components at the placement station takes too long. Now, before leaving the placement station or before entering the soldering station 3 of the PCB assembly production an automatic optical inspection is performed at a placement inspection station 2. To that end, an image of the PCB assembly, e.g., using a camera I, is acquired. The image is then analyzed, wherein the analysis comprises an object-based analysis of the image for recognizing at last one component placed on the PCB B. Thereby, it is determined whether the at least one component is placed on the PCB B based on a comparison between a finding of the object-based analysis and stored assembly information for the PCB B. The result of the comparison may be displayed to the worker W at the inspection station 2 and/or the placement station 1 in order to exchange the wrongly placed components A-A4 or to place one or more missing components A1-A4 on the PCB B.

If it is determined by the object-detection analysis that all the electrical components are placed correctly, the PCB assembly may continue to be transported to the soldering station 3. For example, the PCB assembly C may be placed in the tower T of the soldering device at the soldering station 3.

If, however, it is determined that not all the electrical components A1-A4 are placed correctly, the PCB assembly C may not continue to the further production steps, e.g., may not continue to be transported to the soldering station 3.

It should be noted that for the PCB assembly C to continue to the further production steps the automatic optical inspection is a mandatory step, i.e. all PCBs assemblies C need to be analyzed before production can continue. In order to initiate the optical inspection, the worker may need to press a button at the inspection station 3.

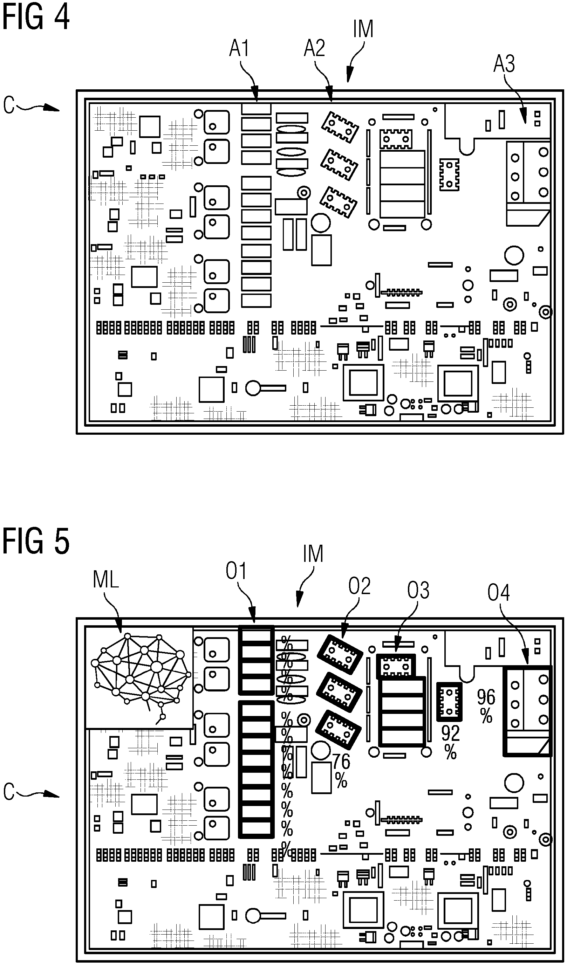

Now turning to Figure 4, an image IM of a PCB assembly C is shown. The PCB assembly C comprises a PCB B and electrical components A1-A3 placed on the PCB B, e.g., via THT. The image IM may be captured by a camera that is mounted at the inspection station 2. As can be seen in Figure 4, the image IM shows the upper side of the PCB B, i.e. the side on which the electrical components A1-A3 are placed.

The image IM may be subject to an object-detection analysis for recognizing at last one component A1-A3 placed on the PCB B. The result of the object-detection analysis is shown in Figure 5, where the objects 01-04 identified are framed. The analysis may assign a probability of the correctness of the identification to the objects 01-04 identified. If the probability is below a certain threshold, e.g., below 75%, the PCB assembly C and the corresponding electrical component A1-A3 may need to be checked before production of the PCB assembly C may continue. The object-detection analysis is a computer-implemented method that serves for assigning at least one object 01-04 to a component A1-A3 identified on the PCB B. The object-detection analysis may be performed by a trained machine learning model ML, as depicted in Figure 5.

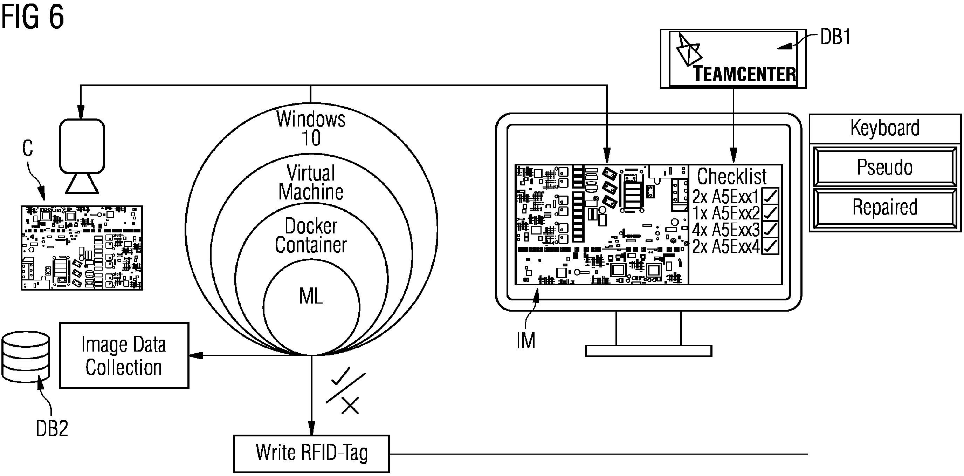

Further details of the system and corresponding steps for inspecting a PCB assembly C are shown in Figure 6. An image IM of the PCB assembly may be captured by a camera, e.g., at placement inspection station 2 of Figure 3, and thus acquired for performing the object-detection. The machine learning model ML may be hosted in a virtual machine on an operating system, such as windows 10. The machine learning model ML itself may be part of a container, such as a docker container, and run on the virtual machine. The image IM may be processed by the machine learning model ML and the objects identified may be overlaid on the image IM acquired and displayed, e.g., to a worker at the placement inspection station. In addition, a list of electrical components identified may be displayed to the worker on a display. The list of electrical components may be retrieved from a database DB1 or planning system, such as Teamcenter.

In case the object detection identifies all electrical components to be placed on the PCB, the PCB assembly may continue to the next production step. To that end, a result of the inspection may be written on a tag G. For example, one or more settings for the subsequent step of soldering the PCB assembly may be written on the tag. The tag G may be attached to a tray Y the PCB assembly is located on. For example, the tag G may be an RFID-tag, comprising a re-writeable memory. In particular, the PCB type or an identifier of the PCB may be written on the tag. The PCB assembly may then be transported to the soldering station, e.g., as shown in Figure 3, where the PCB type and/or the PCB identifier may be read from the tag. Based on setting on the tag G the soldering device may adapt the soldering process. In order to control the soldering process, the soldering device may comprise a soldering program. A setting for a soldering program may comprise a temperature setting for a part of a soldering device, e.g. a soldering iron, tweezers, micro tweezers, de-soldering iron, and hot air, etc.

In case the object detection does not identify all electrical components to be placed on the PCB the process is halted and the PCB assembly is repaired, e.g., by exchanging one or more electrical components on the PCB or by placing one or more additional components on the PCB. After repairing the PCB assembly, a new image of the PCB assembly is acquired, and the object-detection is re-run for the repaired PCB assembly. In such a case a corresponding code may be written on the tag or the field for identifying the PCB and/or the corresponding settings for soldering may (intentionally) be left empty. Then, the production may be halted, i.e. at least interrupted when the PCB assembly arrives at the soldering station, e.g., at the location the tag on the tray is read out. In such a case the worker may need to remove the PCB assembly from the tray before the production process may continue.

Instead of repairing the PCB assembly as just described, the case may appear that the object-detection analysis is at fault. That is to say, the object-detection analysis may determine that one or more components are missing or that one or more wrong components have been placed on the PCB. In that case the worker may identify a pseudo-error, by acquitting a corresponding (virtual) button. Thereafter, one or more settings for soldering the PCB assembly by a soldering device may be written on the tag.

In addition, to the object-detection the image of the PCB assembly acquired may be stored in a database DB2. The images stored in the database DB2 may serve for (re-)training the machine learning model ML used for the object-detection analysis. Hence, a plurality of images IM may be acquired during the production of PCB assemblies C in order to (re-)train the machine learning model ML.

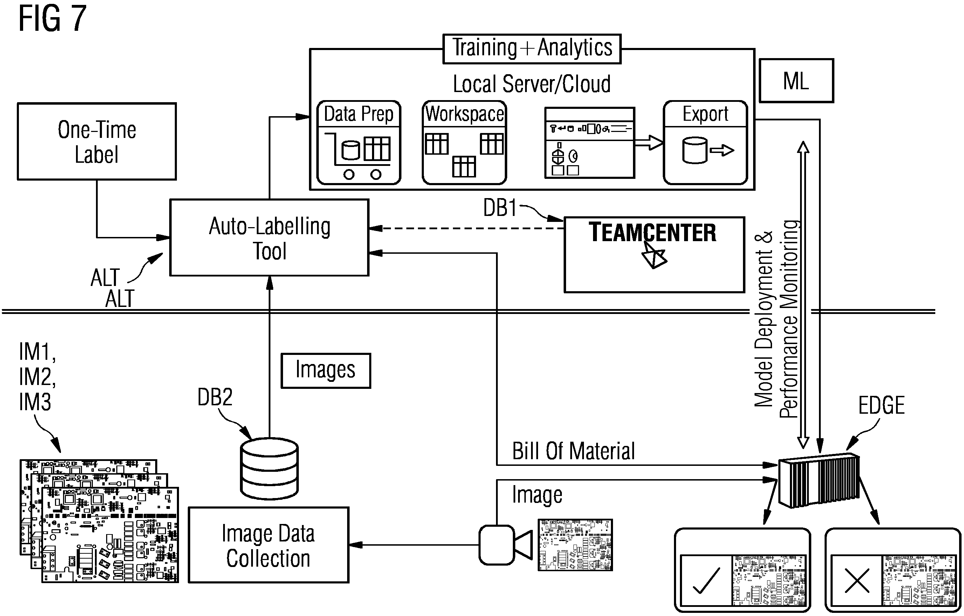

Turning to Figure 7, a system and corresponding steps for training a machine learning model ML in order to perform an object-detection of an image of a PCB assembly C is shown. During production of PCB assemblies, images IM1, IM2, IM3 of the PCB assemblies C assembled may be captured and stored in a database DB2 for the purpose of image data collection. In order to effortlessly label the images IM1, IM2, IM3 and use them for training of a machine learning model ML, the images IM1, IM2, IM3 may be loaded into or read by an auto-labelling tool ALT. The auto-labeling tool ALT carries out the labeling of the images IM1, IM2, IM3. Instead of labeling all of the images IM1, IM2, IM3 acquired manually a one-time label is used. To that end, a template is used for labeling the images IM1, IM2, IM3. The auto-labelling may be based on a template matching algorithm, which detects the offset of the PCB (of the template image) relative to the image boundaries for each of the images IM1, IM2, IM3. Doing this, the labels defined in the template image are transferred from image-coordinate-system to PCB-coordinate-system (of the template) for each image, thereby allowing the algorithm to auto-label every image in the database DB2 and to subsequently use the auto-labeled images for training the ML object-detection algorithm.

The template for labeling may be an image that has been labeled manually. The labeling of the template is then transferred by the auto-labeling tool to the one or more images IM1, IM2, IM3 previously stored in the database DB2. Hence, the images IM1, IM2, IM3 acquired do not have to be labeled manually, but rather suitable images for the auto-labeling are chosen to be stored in the database DB2. Choosing suitable images may be automated according to one or more predetermined criteria or may be done manually by a user. Hence, the labeling associated one or more objects detected in the image with one or more electrical components.

Once the images IM1, IM2, IM3 are labeled, i.e. the objects or electrical components identified, the machine learning model may be (re-)trained based on the now labeled images IM1, IM2, IM3.

After training the machine learning model ML, the model ML may be deployed on a industrial PC or integrated into the production system for producing one or more PCB assemblies, e.g., integrated in an existing infrastructure. For example, the machine learning model ML may be deployed on a control unit of an inspection system, e.g. for controlling the placement inspection station. The inspection system or inspection station may itself be integrated in a production system for producing PCB assemblies. The production system comprising, e.g., placement station, inspection station and soldering station, for example as Figure 3.

As shown in Figure 7, the auto-labeling tool ALT may obtain information of electrical components, e.g., in form of a list, for a specific PCB assembly or a plurality of PCB assemblies of a specific type from a database DB1 or planning system, such as Teamcenter or NX. The information may be used to label the one or more images IM1, IM2, IM3 in the database DB1 by the auto-labeling tool ALT. It should be understood that the auto-labeling tool ALT is software program comprising suitable interfaces, e.g., APIs, to the database DB1, the database or planning system DB2 and the inspection and/or production system, as the case may be.

Hence, once deployed, e.g., as shown in Figure 7, on an edge device EDGE, the machine learning model ML may receive images from the camera C at the inspection station and may also receive a Bill of Materials, e.g., from the database or planning system DB1, for example via the auto-labeling tool ALT, related to the PCB assembly C as captured on the image acquired. The machine learning model ML may then determine on or more components A1-A4 as present in the bill of materials, BOM, in the image of the PCB assembly acquired.

A bill of materials or product structure (sometimes bill of material, BOM or associated list) is a list of the raw materials, sub-assemblies, intermediate assemblies, subcomponents, parts, and the quantities of each needed to manufacture an end product. In general, assembly information for the PCB assembly may be obtained by the machine learning model ML. For example, a list of components to be placed on the PCB can be stored within the production system, the inspection station, or the edge device.

Accordingly, the machine learning model ML may infer whether a PCB assembly as captured on the image processed is fully equipped or is missing one or more electrical components or whether the wrong electrical components have been placed on the PCB.

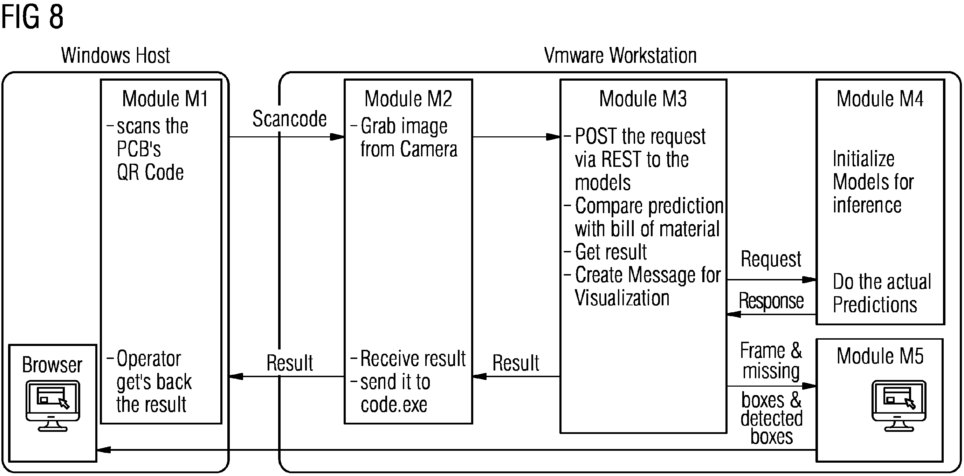

Now turning to Figure 8, a workflow for inspecting a PCB assembly and the integration of the inspection in a production (line) of PCB assemblies is shown.

The workflow may be implemented by one or more software program modules M1-M5. The first module M1 may run directly on an operating system and may serve for scanning an identifier of the PCB assembly. For example, the first module may serve for identifying the PCB assembly based on an identifier, e.g. a 2D-barcode, arranged on the PCB assembly, wherein the identifier serves for identifying an object-based analysis program from a plurality of object-based analysis programs for recognizing at last one component placed on the PCB.

The identifier may then be transmitted to the second module M2. The second module M2 may acquire an image (grab a frame) from the camera at the inspection station.

The identifier and the image may then be transmitted to a third module M3 that retrieves the bill of material or other assembly information, preferably comprising the electrical components to be place on the PCB assembly, for the PCB assembly to be assembled, e.g., based on the identifier.

Further, the image and the identifier may be transmitted to a fourth module M4. The fourth module may select, e.g. based on the identifier, the suitable machine learning model from a plurality of machine learning models, wherein each of the plurality of machine learning models is adapted to a specific PCB assembly, i.e. a PCB assembly type, and hence trained in order to identify the components for said specific PCB assembly type. Having selected the suitable machine learning model the inference may be performed by the machine learning model. The inference may comprise object-detection based on the image received. Having completed the object-detection and associated the corresponding electrical components on the image, the components identified may transmitted to the third module M3 again, where the electrical components identified are compared to the bill of materials as previously received.

For the purpose of visualization frames may be added to the objects detected on the image processed, as previously described, using a fifth module M5. Also missing components may be visualized by adding a frame to the part of the image of the PCB assembly where the missing component should be placed or where the faulty component is placed on the PCB assembly.

The result of the comparison between the components identified by the object detection analysis and the assembly information from the third module M3 may be transmitted to the second module M2 from where it is forwarded to the first module M1 The result of the comparison may for example be pass or fail, i.e. binary.

It should be understood that the modules M1-M5 may be combined with one another to form either a single module or that the functions may be split differently between the modules or that the functions of the modules may be combine to another number of modules.

Finally, the result may be displayed for example in a browser. As can be seen in Figure 8, the visualization of module M5 may be exposed to the host operating system.

The result of said comparison may subsequently be used to control the further production steps of the of the PCB assembly. That is to say, as described in the above, that settings or other information may be written, based on result of the comparison, on a tag of the tray Y which the PCB assembly is transported. Said settings may serve to control further the further production steps of the PCB assembly. For example, the soldering of the PCB assembly may thereby be controlled.

## Claims

1. A method of inspecting a printed circuit board, PCB, assembly (C) comprising the steps of:
acquiring an image (IM) of the PCB assembly (C), e.g., using a camera, and analyzing the image (IM), wherein the analysis comprises an object-based analysis of the image (IM) for recognizing at last one component (A) placed on the PCB (B),
and determining whether the at least one component (A) is placed on the PCB (B) based on a comparison between a finding of the object-based analysis and stored assembly information for the PCB (B).

2. The method according to the preceding claim comprising the step of:
writing based on a result of the comparison, one or more settings for soldering, by a soldering device, the PCB assembly (C), wherein preferably the settings comprise a PCB type and/or a PCB ID.

3. The method according to any one of the preceding claims comprising the step of:
loading, based on a result of the comparison, one or more settings for soldering, by a soldering device, the PCB assembly (C).

4. The method according to any one of the preceding claims comprising the step of:
preventing writing, based on a result of the comparison, of one or more settings for soldering the PCB assembly (C) by a soldering device.

5. The method according to any one of the preceding claims comprising the step of:
halting, based on a result of the comparison, production of the PCB assembly (C).

6. The method according to any one of the preceding claims comprising the step of:
identifying, based on the comparison, at least one missing component on the PCB assembly (C), and preferably repairing the PCB assembly (C) according to the determined missing component, and
writing, based on a result of the comparison, one or more settings for soldering the PCB assembly (C) by a soldering device.

7. The method according to any one of the preceding claims comprising the step of:
identifying, based on a result of the comparison, a pseudo-error, and
writing, based on a result of the comparison, one or more settings for soldering the PCB assembly (C) by a soldering device.

8. The method according to any one of the preceding claims comprising the step of:
arranging the PCB assembly (C) on a tray (Y), wherein the tray (Y) comprises a re-writeable memory (G), e.g., a RFID tag, for storing one or more settings.

9. The method according to any one of the preceding claims comprising the step of:
identifying the PCB assembly based on an identifier, e.g. a 2D-barcode, arranged on the PCB assembly, wherein the identifier serves for identifying an object-based analysis program from a plurality of object-based analysis programs for recognizing at last one component placed on the PCB (B) .

10. The method according to any one of the preceding claims, wherein the object-based analysis program comprises a trained machine learning model (ML).

11. The method according to any one of the preceding claims comprising the step of:
producing PCB assemblies (C) of different types and loading an object-based analysis program based on the PCB assembly (C) typed identified by the identifier.

12. The method according to any one of the preceding claims comprising the step of:
receiving stored assembly information for the PCB (B), e.g., in form of a bill of materials, from an engineering or planning system, e.g., TEAMCENTER, for production of the PCB assembly (C).

13. A method of training a machine learning model (ML) of an object-based analysis program, comprising the steps of:
acquiring a plurality of images of a PCB assembly (C), preferably for different types of PCB assemblies (C), most preferably during production of the PCB assembly, selecting, from the plurality if images (IM1, IM2, IM3), images suitable for training the machine learning model, automatically labeling the plurality of images (IM1, IM2, IM3) based on a template for labeling of the PCB assembly (C),
training the machine learning model (ML) based on the labeled images (IM1, IM2, IM3).

14. An inspection system (2) for inspecting a printed circuit board, PCB, assembly comprising:
a camera (I) for acquiring an image (IM) of the PCB assembly (C) and
a control unit for analyzing the image, wherein the analysis comprises an object-based analysis of the image for recognizing at last one component (A1-A4) placed on the PCB (B),
the control unit further serves for determining whether the at least one component (A1-A4) is placed on the PCB (B) based on a comparison between a finding of the object-based analysis and stored assembly information for the PCB (B) .

15. A production system (1, 2, 3) for producing printed circuit board assemblies (C) comprising the inspection system (2) according to the preceding claim and a soldering device (3) that is connected to the inspection system.
